Europäisches Patentamt

European Patent Office

Office européen des brevets

(19)

(11) Numéro de publication: **0 225 238 B1**

## FASCICULE DE BREVET EUROPEEN

(45) Date de publication de fascicule du brevet:
24.07.91

(51) Int. Cl.⁵: **G06K 19/06, H01L 23/48**

(21) Numéro de dépôt: **86402464.1**

(22) Date de dépôt: **04.11.86**

(54) Cartes comportant un composant et micromodule à contacts de flanc.

(30) Priorité: **08.11.85 FR 8516603**

(43) Date de publication de la demande:
**10.06.87 Bulletin 87/24**

(45) Mention de la délivrance du brevet:
**24.07.91 Bulletin 91/30**

(84) Etats contractants désignés:
**CH DE ES FR GB LI NL**

(56) Documents cités:
**EP-A- 0 095 391**
**FR-A- 2 213 599**
**FR-A- 2 483 128**
**FR-A- 2 495 839**

(73) Titulaire: **THOMSON COMPOSANTS MILITAI-
RES ET SPATIAUX**
**173, Bd Haussmann**
**F-75008 Paris(FR)**

(72) Inventeur: **Gloton, Jean-Pierre**
**THOMSON-CSF SCPI 19, avenue de Messine**
**F-75008 Paris(FR)**

(74) Mandataire: **Guérin, Michel et al**
**THOMSON-CSF SCPI**
**F-92045 PARIS LA DEFENSE CEDEX 67(FR)**

## Description

La présente invention concerne une carte comportant un composant et un micromodule adapté à une telle carte. Elle trouve application dans les domaines de la fabrication et de l'utilisation des cartes de contrôle ou de monnaie électronique.

De l'art antérieur on sait constituer des cartes de paiement ou de contrôle électronique au format carte de crédit dans lesquelles sont disposés des composants électroniques de type micro-ordinateur à mémoire qui déchargent les terminaux d'une partie du travail "intelligent". On distingue selon les métiers propres à la fabrication de la carte elle-même de la fabrication du composant lui-même ou de l'association des deux composants ensembles. Le micromodule qui comporte le composant intégré dans la carte est généralement fabriqué par un fabricant de circuit intégré. Les procédés de fabrication utilisés sont dérivés directement des chaines de fabrication de boitier de circuits semiconducteurs intégrés.

Le document FR 24983128 montre un tel micromodule. Le micromodule comporte `les contacts d'accès de la carte . Par ailleurs, le brevet EP 0095391 montre un boîtier de circuit intégré enfichable sur un support lui-même destiné à être monté sur un circuit imprimé.

La présente invention propose un nouveau micromodule et une nouvelle carte spécialement destiné à permettre l'utilisation de chaines classiques de fabrication de circuits intégrés pour la fabrication de telles cartes. D'autre part, elle présente l'avantage de permettre que le circuit semiconducteur intégré puisse être facilement changé sur la carte. Il est ainsi possible de recycler les cartes à la fin d'une période d'utilisation.

En effet, la présente invention concerne une carte comportant un composant semiconducteur du type comportant des connexions électriques disposées en des points déterminés selon une norme sur un support au format carte de crédit. Une carte selon l'invention comporte au moins un logement sur une face portant les connexions et dont les flancs portent des contacts de transfert qui relient électriquement des connexions de carte à des bornes d'un micromodule enfiché dans le logement.

L'invention concerne aussi un micromodule spécialement adapté à une carte CCC selon l'invention.

D'autres caractéristiques et avantages de la présente invention seront mieux compris à l'aide de la description et des figures annexées qui sont :
- la figure 1 : un schéma en coupe d'un micromodule selon l'invention,
- la figure 2 : une vue partielle d'une carte CCC selon l'invention.

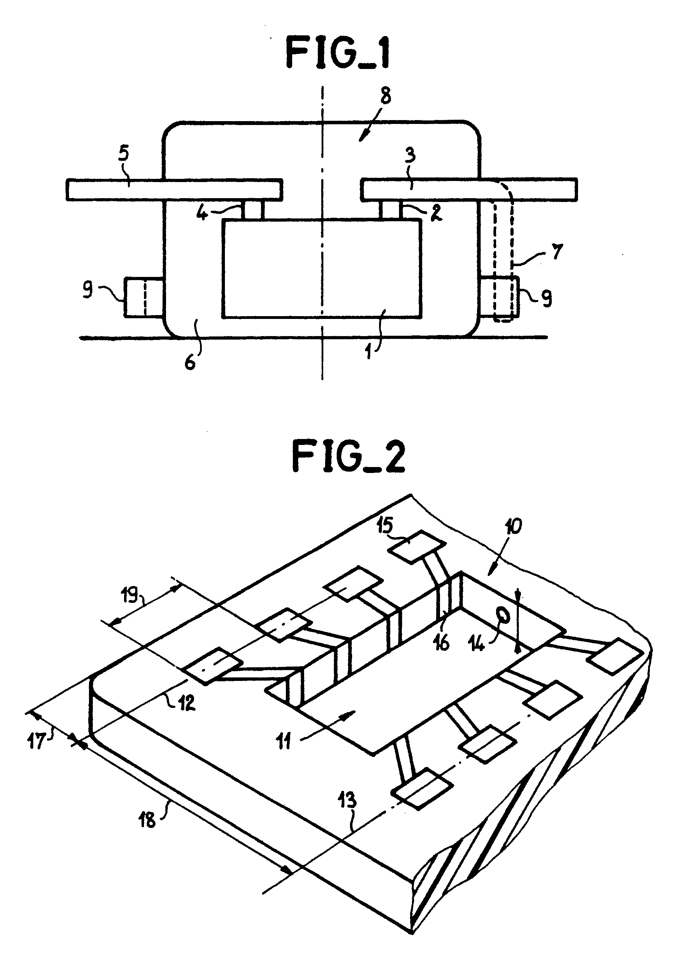

A la figure 1 on a représenté une vue partielle d'un micromodule adapté à la présente invention. Un circuit intégré 1 est fabriqué à partir d'une pastille de silicium semiconducteur. Des connexions 2, 4 sont constituées par un métal d'apport en plots particulièrement convenables à un procédé continu de connexion. Le circuit semiconducteur est disposé sur un support 6 qui constituera une partie d'un boitier en résine complet 8. Un film métallique constitué de bras de connexions comme les bras 3 et 5 sont disposés automatiquement au-dessus de la série des plots 2, 4. Par soudage on relie chaque bras à une connexion correspondante. Puis le reste du boitier est constitué par surmoulage de l'ensemble. Enfin, chaque bras de connexions 3, 5 est sectionné de façon à quitter le ruban de connexion. Un tel procédé est connu de la littérature anglo-saxonne sous les initiales TAB (tape automatic bonding).

Selon l'invention le contact électrique entre le micromodule et la carte CCC dans laquelle le micromodule sera monté est prévu à flanc. Afin de réaliser une telle connexion l'invention propose de recourber chaque bras latéralement sur les bords du boitier du micromodule. Dans l'exemple de réalisation de la figure 1 on a seulement représenté une ligne tiretée 7 pour indiquer la fin de l'opération de pliage. Dans une variante le boîtier 8 du micromodule est pourvu de moyens de guidage et de maintien des bras de connexion repliés 7. Selon cette caractéristique de l'invention le boitier comporte par moulage des logements dans lequel les bras sont destinés à venir s'encliqueter de façon à rester en permanence dans la position désirée.

A la figure 2 on a représenté une carte CCC qui reçoit un micromodule selon la figure 1. La carte 10 comporte un logement 11 destiné à recevoir le micromodule. De part et d'autre du logement 11 sont disposées deux rangées de connexions 12, 13 chaque connexion comme la connexion 15 étant disposée selon une norme de connexions pré-établie pour les cartes de type CCC. On a figuré des dimensions 17-19 que les connexions sur la carte doivent respecter. Ce sont principalement la distance à un bord 17, l'écartement des deux rangées 18 et le pas entre deux connexions d'une rangée 19. Comme ces dimensions ne correspondent pas aux dimensions standards des connexions connues des normes de fabrication des circuits intégrés à semiconducteur, des connexions de transfert sont prévues qui permettent de ramener les contacts de flanc du micromodule comme le contact 15 sur la carte. A cet effet, des bandes métalliques sont disposées de manière à relier chaque connexion comme la connexion 15 à un contact de flanc disposé convenablement dans le logement 11. Ces bandes métalliques peuvent être obtenues par différents procédés. En particulier il peut s'agir de bandes de métal conducteur collées à la surface de la carte. Dans un autre mode de réalisation les connexions sont réalisées par pressage à chaud de bandes de métal conducteur sur la carte en matière plastique. Dans un autre mode de réalisation les connexions sont déposées sur la carte par sérigraphie. Enfin, dans un autre mode de réalisation les connexions sont déposées sur la carte par projection de métal sous vide.

La carte constituée, il est possible de déposer un circuit semiconducteur dans un micromodule comme le micromodule de la figure 1 dans le logement 11. Le micromodule est installé dans le logement et y est maintenu par l'élasticité des contacts de flanc comme le contact 7. Dans un exemple de réalisation représenté à la figure 2, des moyens d'encliquetage 14 sont prévus dans le logement qui coopèrent avec des moyens correspondant sur le boitier 8 du micromodule. Selon cette caractéristique l'encliquetage réalisé à l'introduction du micromodule sur la carte assure une permanence au cours des manipulations de la carte par un utilisateur normal.

La présente invention présente l'avantage tout d'abord de pouvoir être utilisée dans des chaines de fabrication de circuits intégrés standards. D'autre part, elle présente l'avantage de permettre de rendre distincts les problèmes particuliers de connectiques propres à l'utilisation des cartes électroniques d'une part, des problèmes électroniques des circuits intégrés d'autre part. Elle permet ainsi de rendre amovible le circuit intégré coeur de la carte. On peut donc réutiliser plusieurs fois la carte dans des utilisations variées selon le micromodule utilisé.

**Revendications**

1. Carte comportant un composant semiconducteur du type comportant des connexions (12, 13) électriques disposées en des points déterminés par une norme sur un support (10) au format carte de crédit, la carte comportant au moins un logement (11) sur une face portant les connexions (12, 13), caractérisée en ce que les flancs du logement portent des contacts de transfert (14, 16) qui relient électriquement les connexions (12, 13) à des bornes (7) d'une micromodule enfiché dans le logement.

2. Carte selon la revendication 1, caractérisée en ce que le micromodule (8) comporte un circuit semiconducteur (1) dont des accès électriques (2, 4) sont reliés à des pattes (3, 5) de connexion, l'ensemble étant disposé dans un boitier moulé (6) et les pattes rabattues (7) sur les flancs.

3. Carte selon la revendication 2, caractérisée en ce que le micromodule comporte des moyens (9) de guidage et de maintien des pattes recourbées (7).

4. Carte selon la revendiction 2, caractérisée en ce que le boitier (6) comporte des moyens d'encliquetage dans le logement (11) qui coopèrent avec des moyens correspondants (14) de celui-ci.

5. Carte selon la revendication 1, caractérisée en ce que les connexions (12, 13) sont déposées sur la carte (10) sous forme de bandes de métal conducteur collées.

6. Carte selon la revendication 1, caractérisée en ce que les connexions (12, 13) sont réalisées par pressage à chaud de bandes de métal conducteur sur la carte en matière plastique.

7. Carte selon la revendication 1, caractérisée en ce que les connexions (12, 13) sont déposées sur la carte (10) par sérigraphie.

8. Carte selon la revendication 1, caractérisée en ce que les connexions (12, 13) sont déposées par projection de métal sous vide.

**Claims**

1. A card comprising a semiconductor component of the type comprising electrical connections (12, 13) disposed at points defined by a standard on a support (10) of the credit card size, the card comprising at least one recess (11) on a surface bearing the connections (12, 13), characterized in that the edges of the recess are provided with transfer contacts (14, 16) intended to electrically connect the connections (12, 13) to terminals (7) of a micromodule which is plugged into the recess.

2. A card according to claim 1, characterized in that the micromodule (8) comprises a semicondcutor circuit (1) whose electrical terminals (2, 4) are connected to connection lugs (3, 5), the whole being disposed in a molded casing (6) and the lugs being bent (7) onto the edges.

3. A card according to claim 2, characterized in that the micromodule comprises means (9) for guiding and maintaining the bent lugs (7).

4. A card according to claim 2, characterized in that the casing (6) comprises means allowing to snap the casing into the recess (11), these means cooperating with corresponding means (14) of the latter.

5. A card according to claim 1, characterized in that the connections are deposited on the card (10) in the form of glued metal conductor strips.

6. A card according to claim 1, characterized in that the connections (12, 13) are realized by hot pressing of metal conductor strips on the card which is made of plastic material.

7. A card according to claim 1, characterized in that the connections (12, 13) are deposited on the card (10) by a serigraphic method.

8. A card according to claim 1, characterized in that the connections (12, 13) are deposited on the card by projecting metal under vacuum conditions.

**Patentansprüche**

1. Karte mit einem Halbleiterbauteil und mit elektrischen Anschlüssen (12, 13), die an durch eine Norm bestimmten Stellen auf einem Träger (10) im Kreditkartenformat liegen, wobei die Karte mindestens eine Vertiefung (11) auf einer die Anschlüsse (12, 13) tragenden Seite besitzt, dadurch gekennzeichnet, daß die Flanken der Vertiefung Transferkontakte (14, 16) tragen, die die Anschlüsse (12, 13) mit Anschlußfahnen (7) eines in die Vertiefung eingesteckten Mikromoduls elektrisch verbinden.

2. Karte nach Anspruch 1, dadurch gekennzeichnet, daß der Mikromodul (8) einen Halbleiterschaltkreis (1) besitzt, dessen elektrische Anschlüsse (2, 4) mit Anschlußlaschen (3, 5) verbunden sind, wobei das Ganze in einem gegossenen Gehäuse (6) angeordnet ist und die Anschlußlaschen auf die Flanken umgebogen sind (7).

3. Karte nach Anspruch 2, dadurch gekennzeichnet, daß der Mikromodul Mittel (9) zur Führung und Halterung der umgebogenen Anschlußlaschen (7) aufweist.

4. Karte nach Anspruch 2, dadurch gekennzeichnet, daß das Gehäuse (6) Mittel aufweist, die ein Einrasten in der Vertiefung (11) ermöglichen und mit entsprechenden Mitteln (14) in der Vertiefung zusammenwirken.

5. Karte nach Anspruch 1, dadurch gekennzeichnet, daß die Anschlüsse (12, 13) auf der Karte (10) in Form von aufgeklebten Streifen aus leitendem Metall aufgebracht sind.

6. Karte nach Anspruch 1, dadurch gekennzeichnet, daß die Anschlüsse (12, 13) durch Heißpressen von Streifen aus leiten-dem Metall auf die Karte aus Kunststoffmaterial hergestellt sind.

7. Karte nach Anspruch 1, dadurch gekennzeichnet, daß die Anschlüsse (12, 13) durch Seriegraphie auf die Karte (10) aufgebracht sind.

8. Karte nach Anspruch 1, dadurch gekennzeichnet, daß die Anschlüsse (12, 13) durch Metallaufsprühen unter Vakuum aufgebracht sind.

# FIG_1

# FIG_2